# EUROPEAN PATENT APPLICATION

(11) **EP 3 892 975 A1**
(43) Date of publication of application: **13.10.2021**
(21) Application number: 21167528.5
(22) Date of filing: 08.04.2021
(51) Int. Cl.: G01L 1/22

(54) **STRAIN SENSOR MODULE**

(30) Priority: 10.04.2020 JP 2020070787
(71) Applicant: Hosiden Corporation, Yao-shi, Osaka 581-0071 (JP)
(72) Inventor: SHINODA, Koji, Yao-shi, Osaka 581-0071 (JP)
(74) Representative: MERH-IP Matias Erny Reichl Hoffmann Patentanwälte PartG mbB

(57) **Abstract**

A strain sensor module comprises a base material, a sensor part including a plurality of sensor electrodes for detecting a strain formed on the base material and a lead-out wiring for connecting the plurality of sensor electrodes in series, and a terminal part which is electrically connected to an external circuit.

## Description

### TECHNICAL FIELD

The present invention relates to a strain sensor module.

### BACKGROUND ART

Japanese Registered Patent No. 5431527 (hereinafter referred to as "Patent Literature 1") discloses a modular type force sensor for enhancing sensitivity of force and torque and feedback to a surgeon who performs remote robotic surgery.

One embodiment of Patent Literature 1 discloses a module type force sensor including a tube part containing a plurality of strain gauges, a proximal tube part to be operably coupled to a shaft of a surgical instrument that can be operably coupled to a manipulator arm of a robotic surgery system, and a distal tube part to be proximally connected to a wrist joint which is connected to a terminal part.

When attempt is made to detect a load or a stress by using an existing strain sensor, it is common practice to adopt such a manner of using a beam structure and attaching a strain sensor (generally, of a small size) to a point where a beam strain is concentrated. However, this also requires a housing design that allows a beam to sag, and places a limitation on a location where the sensor can be installed. For example, there is no room to introduce a beam structure into automobile steering.

### SUMMARY OF THE INVENTION

Therefore, an object of the present invention is to provide a strain sensor module capable of obtaining a large output with a simple structure.

A strain sensor module according to the present invention comprises a base material, a sensor part, and a terminal part.

The sensor part comprises a plurality of sensor electrodes for detecting strain formed on the base material, and a lead-out wiring for connecting the plurality of sensor electrodes in series. The terminal part is electrically connected to an external circuit.

### EFFECTS OF THE INVENTION

According to the strain sensor module of the present invention, a large output can be obtained with a simple structure.

### BRIEF DESCRIPTION OF THE DRAWING

Fig. 1 is a schematic diagram of a strain sensor module of a first embodiment;
Fig. 2 is a schematic cross-sectional view of the strain sensor module installed in a steering wheel;
Fig. 3 is a diagram illustrating a circuit configuration when a bridge circuit including sensor electrodes is configured;
Fig. 4 is a schematic diagram of a strain sensor module of a first modification; and
Fig. 5 is a schematic diagram of a strain sensor module of a second modification.

### DETAILED DESCRIPTION

Hereinafter, embodiments of the present invention will be described in detail. Note that constituent parts having the same functions are designated by the same reference numbers, and duplicate description thereof will be omitted.

### FIRST EMBODIMENT

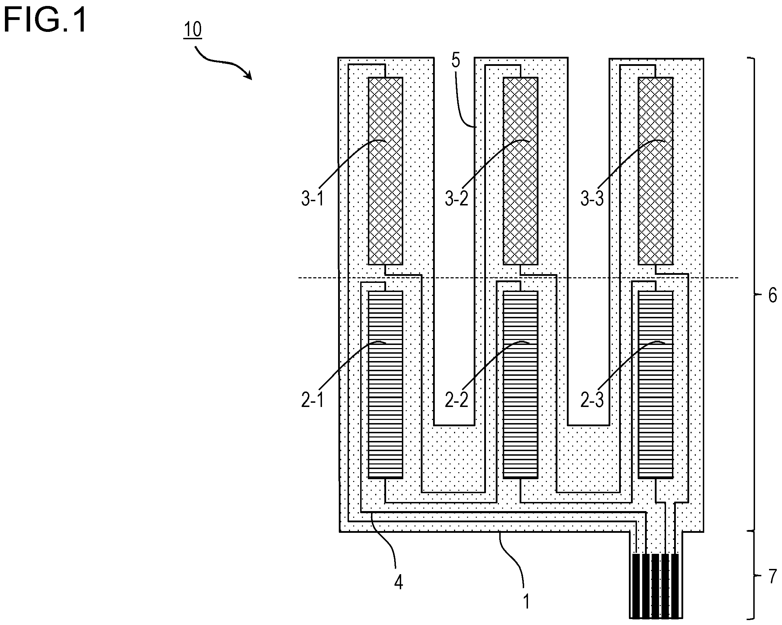

Hereinafter, a configuration of a strain sensor module of a first embodiment will be described with reference to Fig. 1. As shown in Fig. 1, the strain sensor module 10 of the present embodiment comprises a base material 1, a sensor part 6, and a terminal part 7.

The sensor part 6 comprises a plurality of sensor electrodes 2-1, 2-2, 2-3, 3-1, 3-2 and 3-3 for detecting a strain formed on the base material 1, and lead-out wirings 4 for connecting the sensor electrodes 2-1, 2-2 and 2-3 in series and connecting the sensor electrodes 3-1, 3-2 and 3-3 in series. The sensor electrodes 2-1, 2-2, 2-3, 3-1, 3-2, and 3-3 and the lead-out wirings 4 may be formed by a printing method or by a photolithography method or the like. The lead-out wirings 4 are connected to the terminal part 7. The terminal part 7 is electrically connected to an external circuit. Note that the number of sensor electrodes is not limited to the example shown in Fig. 1, and may be any number as long as it is two or more. Further, in the example of Fig. 1, two series circuits (a series circuit including the sensor electrodes 2-1, 2-2, and 2-3 and a series circuit including the sensor electrodes 3-1, 3-2, and 3-3) are provided, but the number of the series circuits may be any number of one or more. The strain sensor module 10 of the present embodiment is characterized in that the sensor electrodes are connected to one another in series to form a single large sensor electrode (sensor electrode group). In the case of gripping pressure detection, the deformation direction of the sensor electrodes arranged on the same surface is always constant, so that it is unnecessary to consider a phenomenon that the distortion direction is different from one sensor electrode to another and thus the output is subjected to subtraction. Therefore, by connecting the sensor electrodes in series, resistance changes of the respective sensor electrodes can be added up, and detection sensitivity is enhanced. Further, in the strain sensor module 10 of the embodiment, since the sensor electrodes of each sensor electrode group are connected in series, the number of detection circuits in the subsequent stage can be set to one for each sensor electrode group, so that the circuit scale can be reduced.

The base material 1 may be, for example, a resin film. A material having flexibility and elasticity is suitably used as the base material 1.

As shown in Fig. 1, it is preferable that the plurality of sensor electrodes 2-1, 2-2, 2-3, 3-1, 3-2, and 3-3 are formed in a row on the base material 1. In the example of Fig. 1, the plurality of sensor electrodes 2-1, 2-2, and 2-3 are arranged in a row, and the plurality of sensor electrodes 3-1, 3-2, and 3-3 are arranged in a row so as to form another row. Slits 5 are formed between adjacent sensor electrodes on the base material (for example, between the sensor electrodes 2-1 and 2-2, between the sensor electrodes 2-2 and 2-3, between the sensor electrodes 3-1 and 3-2, and between the sensor electrodes 3-2 and 3-3).

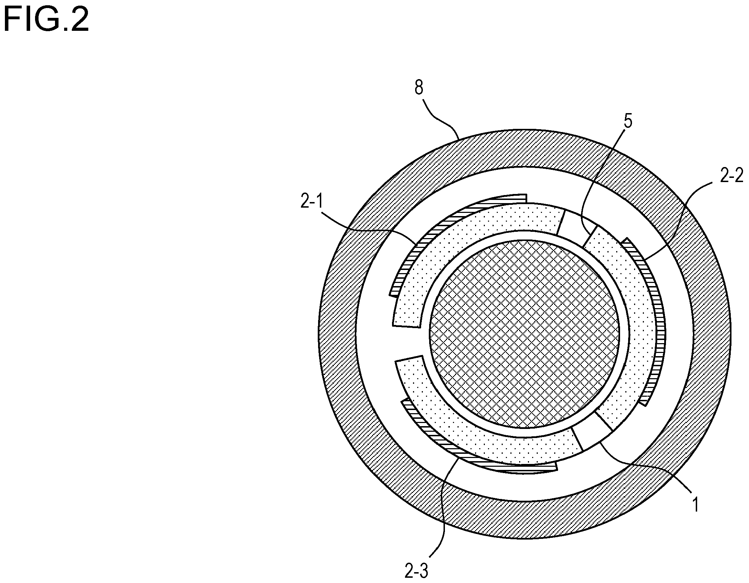

For example, as shown in Fig. 2, by winding the strain sensor module 10 around the steering wheel of an automobile, the pressure on the entire circumference of the steering wheel can be detected. In the example of Fig. 2, the strain sensor module 10 is covered with a steering cover 8 of the steering wheel. Provision of the slits 5 enhances the flexibility (softness) of the base material 1 when the base material 1 is curved and shaped along the curved surface of the steering wheel. Further, all the sensor electrode groups are arranged only on a surface (front surface) side of the base material 1 on which the base material 1 is gripped, so that the signs of resistance changes of all the sensor electrode groups under gripping pressure detection are coincident with one another, and thus the output of each sensor does not cancel the output of another sensor. The same effect can be obtained even when all the sensor electrode groups are arranged on a surface (back surface) side opposite to the surface side on which the base material 1 is gripped.

As shown in Fig. 2, the sensor electrodes 2-1, 2-2, 2-3, 3-1, 3-2, and 3-3 are arranged on only one side (front surface) of the base material 1. However, the base material 1 is folded along a broken line in Fig. 1, and the back surfaces of the folded base material 1 are fixed to each other to form a double-sided electrode structure, whereby electrodes having the same thermal history can be formed on the front and back surfaces.

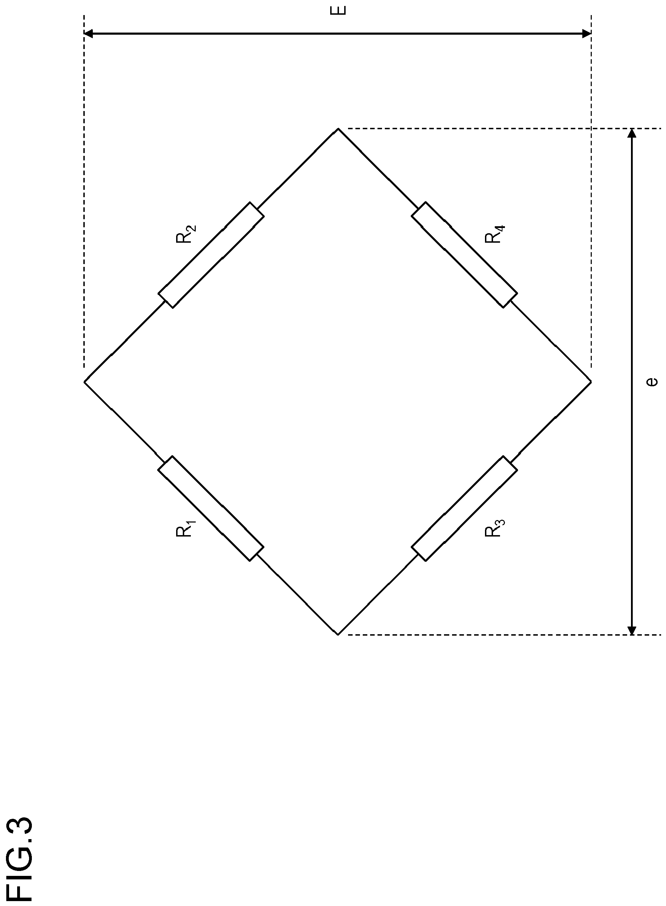

Not limited to the folding example as described above, the sensor electrode groups may be configured in advance on both the front and back surfaces of the base material 1. As a result, the sign of the resistance change is opposite between the sensor electrodes arranged on the front surface and the sensor electrodes arranged on the back surface. When the sensor electrode group formed on the front surface of the base material 1 is referred to as a first sensor part 6-1 and the sensor electrode group formed on the back surface of the base material 1 is referred to as a second sensor part 6-2, both the first sensor part 6-1 and the second sensor part 6-2 are used as gauges for measurement, and the first sensor part 6-1 is represented by R1 in Fig. 3 while the second sensor part 6-2 is represented by R3 in Fig. 3, whereby the strain sensor module 10 may be configured as a half-bridge circuit based on a 2-active gauge method. In this case, gripping a measurement target object causes constriction in the first sensor part 6-1 formed on the front surface of the base material 1, and also causes extension in the second sensor part 6-2 formed on the back surface of the base material 1. As a result, resistance changes in opposite directions occur, so that a bridge voltage E becomes large, and detection sensitivity is enhanced.

Further, when the sensor electrode group formed on the front surface of the base material 1 is referred to as a third sensor part 6-3, and the sensor electrode group formed on the back surface of the base material 1 is referred to as a fourth sensor part 6-4, both the third sensor part 6-3 and the fourth sensor part 6-4 are used as gauges for measurement, and the third sensor part 6-3 is represented by R2 in Fig. 3 while the fourth sensor part 6-4 is represented by R4 in Fig. 3, whereby the strain sensor module 10 may be a full-bridge circuit based on a 4-gauge method. In this case, gripping a measurement target object causes constriction in the third sensor part 6-3 formed on the front surface of the base material 1, and also causes extension in the fourth sensor part 6-4 formed on the back surface of the base material 1. As a result, resistance changes in opposite directions occur, so that a bridge voltage E becomes large, and detection sensitivity is enhanced.

Further, it is preferable that the sensor electrodes arranged on both the surfaces of the base material 1 are arranged at positions where the sensor electrodes overlap each other in a plan view of the base material. When a strain occurs in the base material 1 such that the base material 1 is distorted into a wavy shape, there occurs a case in which the sign of resistance change is not opposite between the electrodes arranged on the front surface and the electrodes arranged on the back surface. However, by arranging these electrodes at the overlapping positions in a plan view of the base material, this phenomenon can be prevented, and the sign of resistance change is always opposite between the front surface and the back surface, and the detection sensitivity is enhanced.

Here, a heater, an electrostatic sensor, a biological sensor or the like may be mounted in the strain sensor module 10. General objects to be gripped such as the steering wheel of an automobile, an operation device such as a game controller or a mouse, a steering wheel, and a grip are assumed as objects in which the strain sensor module 10 of the embodiment is deployed.

### FIRST MODIFICATION

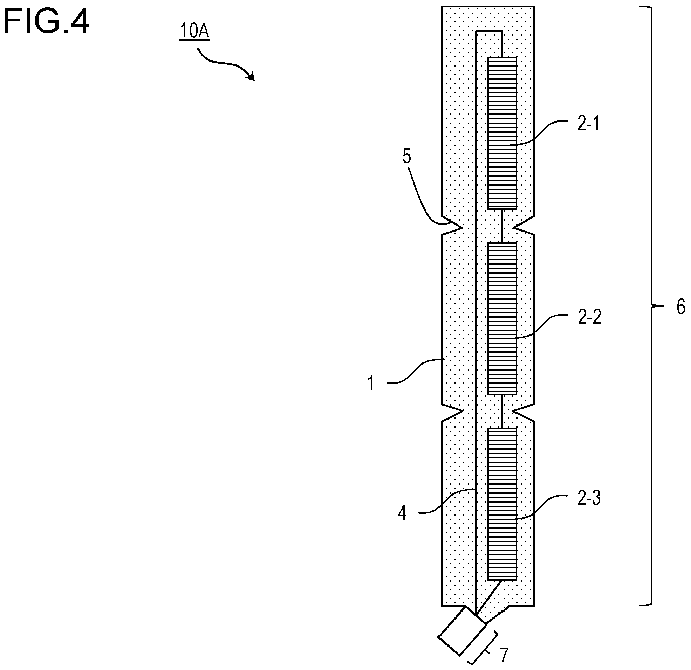

As shown in Fig. 4, the respective sensor electrodes 2-1, 2-2, and 2-3 are arranged in a row along a longitudinal direction, and the slit 5 is formed between the adjacent sensor electrodes (between the sensor electrodes 2-1 and 2-2 in Fig. 4 and between the sensor electrodes 2-2 and 2-3 in Fig. 4).

### SECOND MODIFICATION

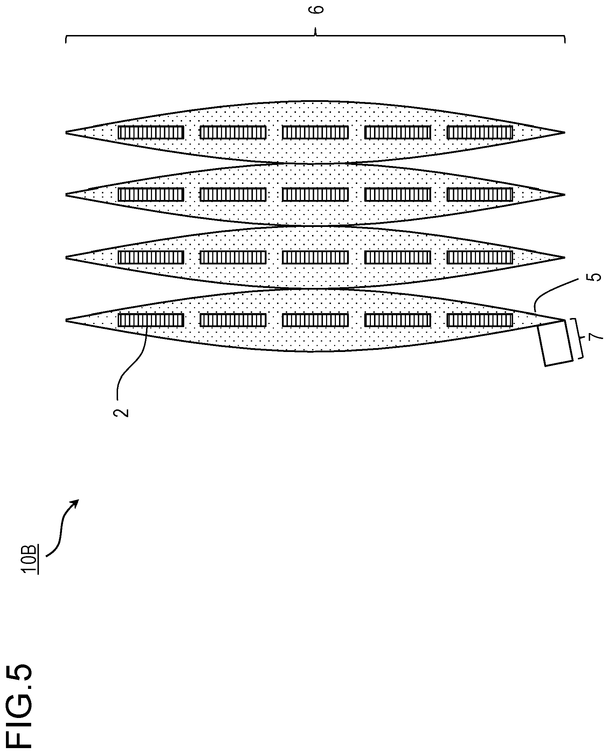

As shown in Fig. 5, a plurality of sensor electrodes 2 may be arranged on a base material formed as a development view of a sphere in order to attach the strain sensor module to an operation device having a sphere-shaped grip part. The development view of Fig. 5 is a development view of a sphere, but by using an upper half or a lower half of the development view, the strain sensor module can also be attached to an operation device with a grip part having a hemispherical (dome-like) shape.

## Claims

1. A strain sensor module comprising
a base material;
a sensor part including a plurality of sensor electrodes for detecting a strain formed on the base material, and a lead-out wiring for connecting the plurality of sensor electrodes in series; and
a terminal part that is electrically connected to an external circuit.

2. The strain sensor module according to claim 1, wherein the plurality of sensor electrodes are formed in a row on the base material, and a slit is formed between adjacent sensor electrodes on the base material.

3. The strain sensor module according to claim 1 or 2, further comprising a first sensor part which is the sensor part formed on a front surface of the base material, and a second sensor part which is the sensor part formed on a back surface of the base material, wherein a half-bridge circuit is formed, the half-bridge circuit being based on a 2-active gauge method in which both the first sensor part and the second sensor part are used as gauges for measurement.

4. The strain sensor module according to claim 3, comprising a third sensor part which is the sensor part formed on a front surface of the base material, and a fourth sensor part which is the sensor part formed on a back surface of the base material, wherein a full-bridge circuit is formed, the full-bridge circuit being based on a 4-gauge method in which both the third sensor part and the fourth sensor part are also used as gauges for measurement.

5. The strain sensor module according to claim 1 or 2, wherein a double-sided electrode structure is formed by folding the base material and fixing back surfaces of the folded base material to each other.

6. The strain sensor module according to any one of claims 3 to 5, wherein the sensor electrodes arranged on both surfaces of the base material are arranged at positions where the sensor electrodes overlap each other in a plan view of the base material.

7. The strain sensor module according to any one of claims 1 to 6, wherein the base material is a resin film.
